Europäisches Patentamt

European Patent Office

Office européen des brevets

(19)

(11) **EP 1 164 633 A2**

(12) **EUROPEAN PATENT APPLICATION**

(43) Date of publication:
**19.12.2001 Bulletin 2001/51**

(51) Int Cl.7: **H01L 21/3213**, H01L 21/28

(21) Application number: **01112920.2**

(22) Date of filing: **05.06.2001**

| | |
|---|---|
| (84) Designated Contracting States:<br>**AT BE CH CY DE DK ES FI FR GB GR IE IT LI LU MC NL PT SE TR**<br>Designated Extension States:<br>**AL LT LV MK RO SI**<br><br>(30) Priority: **07.06.2000 JP 2000169953**<br><br>(71) Applicant: **NEC CORPORATION**<br>**Tokyo (JP)** | (72) Inventor: **Tokashiki, Ken**<br>**Minato-ku, Tokyo (JP)**<br><br>(74) Representative: **Baronetzky, Klaus, Dipl.-Ing.**<br>**Splanemann Reitzner Baronetzky Westendorp**<br>**Patentanwälte Rumfordstrasse 7**<br>**80469 München (DE)** |

(54) **Method for etching an electrode in a semiconductor device**

(57) A photo-resist having a predetermined pattern is formed on a top surface of a Pt layer. Next, the Pt layer is dry-etched by using a mixture of $Cl_2$ and Ar as an etching gas. In this case, etching by-products are deposited on both side surfaces of the photo-resist and the Pt layer is shaped into an electrode. Then, the photo-resist which has become unnecessary after the Pt layer is dry etched is ashed and stripped by oxygen plasma. A Si substrate on which the etching by-products are deposited is soaked in a mixing solution composed of acetoacetylacetone, ammonia and DI water. The etching by-products are easily dissolved and removed.

FIG. 2A

25 PHOTO-RESIST MASK
24 Pt LAYER
23 Ti LAYER
22 $SiO_2$ LAYER
21 Si SUBSTRATE

EP 1 164 633 A2

**(Cont. next page)**

*FIG. 2B*

25
26 ETCHING BY-PRODUCT
24
23
22
21

*FIG. 2C*

26
24
23
22
21

*FIG. 2D*

24
23
22
21

**Description**

FIELD OF THE INVENTION

The invention relates to a method for fabricating a semiconductor device, and especially to a method for fabricating a semiconductor device in which etching by-products deposited on side walls of an electrode in a dry etching process can be removed effectively without dispersion of particles.

In recent years, a capacitor in which precious metal or oxide thereof, such as Ir, Pt, or $IrO_2$, is used as material of an electrode thereof, and a microdevice, such as a dynamic random access memory (DRAM) which is provided with the capacitors using ferroelectric insulating layers, such as strontium titanate layers (STO layers) or barium strontium titanate layers (BTS layers), or a FRAM which uses the aforementioned precious metal and the ferroelectric insulating layers, such as zirconium lead titanate layers (PZT layers) or strontium bithmuth tantalum oxide layers (Y1 layers), is actively developed.

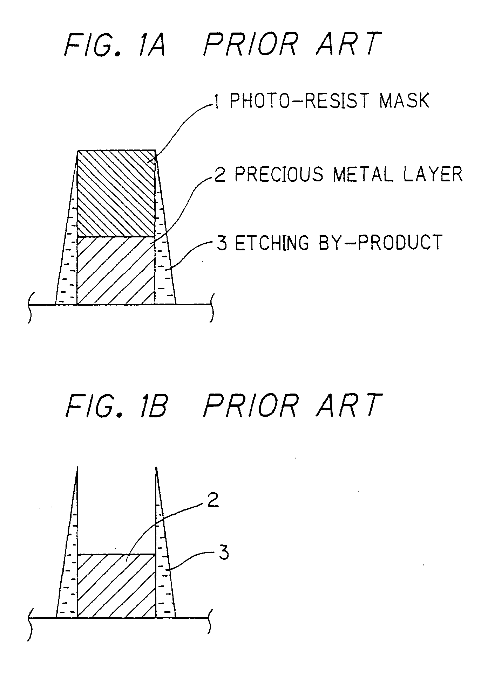

FIGs. 1A, 1B show a fine process of precious metal used in the microdevice.

As shown in FIG.1A, a photo-resist 1 is formed on a precious metal layer 2 formed of Pt or Ir, and deposited films 3 produced as etching by-products are deposited on both sides of the photo-resist mask 1 and the precious metal layer 2. The etching by-product 3 is formed in accordance with a following process that Pt ions which are spattered from and re-deposited on a Pt layer change into a by-product formed of Pt and Cl mixtured compounds.

Next, an etching process for pattering the precious metal layer 2 will be explained. After the photo-resist mask 1 having a predetermined pattern is formed on a surface of the precious metal layer 2, the precious metal layer is dry etched by a halogenous gas, such as a mixture gas of $Cl_2$ and Ar.

After the aforementioned etching process is over, the photo-resist mask 1 which has become unnecessary is ashed and stripped. A state that the resist 1 has been removed is shown in FIG.1B.

Since the saturated vapor pressure of a halogenide of precious metal is low, the deposited films formed of precious metal and the halogenide thereof are stuck to the side walls of the photo-resist mask 1 as the etching by-products 3 after dry etching is over as shown in FIG.1A. Even when the resist mask is ashed and stripped by oxygen plasma, the etching by-product 3 is hard to remove, and remains as residue like a fence. The etching by-product 3 must be removed by a physical method such as scrub cleansing formerly, and a surface of the semiconductor substrate is scrubbed directly.

Moreover, in Japanese Patent Application, Laid-Open, No. 7-130702, a following method is proposed. That is to say, after spatter etching by using $Cl_2$ and Ar mixture gases, deposited materials or the etching by-products which are formed of $PtCl_4$ and adhere to side walls of a photo-resist are simultaneously removed by ethyl alcohol ($C_2H_5OH$), ethyl ether ($C_2H_5OC_2H_5$) or acetone ($CH_3COCH_3$).

However, according to the aforementioned conventional method, when the deposited films (the etching by-products) are removed by scrub cleansing, particles dispersed at that time affects the yield rate of the semiconductor device sharply, and it is difficult to remove the deposited films perfectly.

Stillmore, although it is described in Japanese Patent Applications, Laid-open, No.7-130702 that $PtCl_4$ is dissolved into ethyl alcohol or acetone, since these compounds do not form metallic complex salt, it is difficult to remove the etching by-products by this method.

SUMMARY OF THE INVENTION

Accordingly, it is an object of the invention to provide a method for fabricating a semiconductor device in which etching by-products deposited on side surfaces of an electrode is removed effectively without dispersion of particles and the yield rate and the productivity of a semiconductor device can be improved.

According to a feature of the invention, a method for fabricating a semiconductor device comprises the steps of:

forming a photo-resist mask having a predetermined pattern on a surface of an electrode formed of material of one kind selected from Pt, Ir, and $IrO_2$, dry etching the electrode by using etching gas in accordance with a pattern of the photo-resist mask, removing the photo-resist mask by ashing, and removing etching by-products deposited on both side surfaces of the electrode patterned by the dry etching by dissolving.

According to this method, when an electrode formed of Pt or Ir is etched, etching by-products deposited on side surfaces of the lectrode are removed easily by dissolving after the photo-resist mask has been removed by ashing. As a result, since the etching by-products are removed surely and particles are not dispersed, the yield rate of the semiconductor device is heightened, and the productivity thereof can be improved.

BRIEF DESCRIPTION OF THE DRAWINGS

The invention will be explained in more detail in conjunction with appended drawings, wherein:

FIG.s 1A, 1B show a conventional method for fabricating a semiconductor device, wherein FIG.1A shows a state that etching by-products are deposited on side surfaces of an electrode formed of precious metal, and FIG.1B is a cross sectional view for showing a state that etching by-products remain on a substrate as residues like fences, after a photo-resist mask is ashed and stripped,

FIG.s 2A to 2D show the steps of a method for fabricating a semiconductor device according to the invention, and

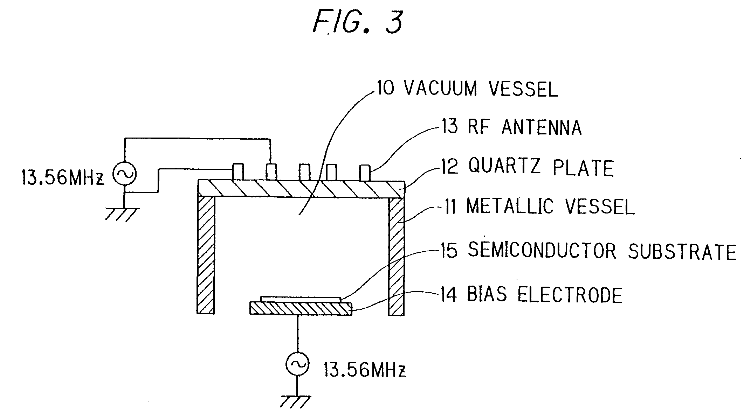

FIG.3 is a cross-sectional view for showing an etching apparatus used in a method for fabricating a semiconductor device according to the invention.

## DESCRIPTION OF THE PREFERRED EMBODIMENTS

Hereafter, preferred embodiments of the invention will be explained referring to the appended drawings.

[THE FIRST PREFERRED EMBODIMENTS]

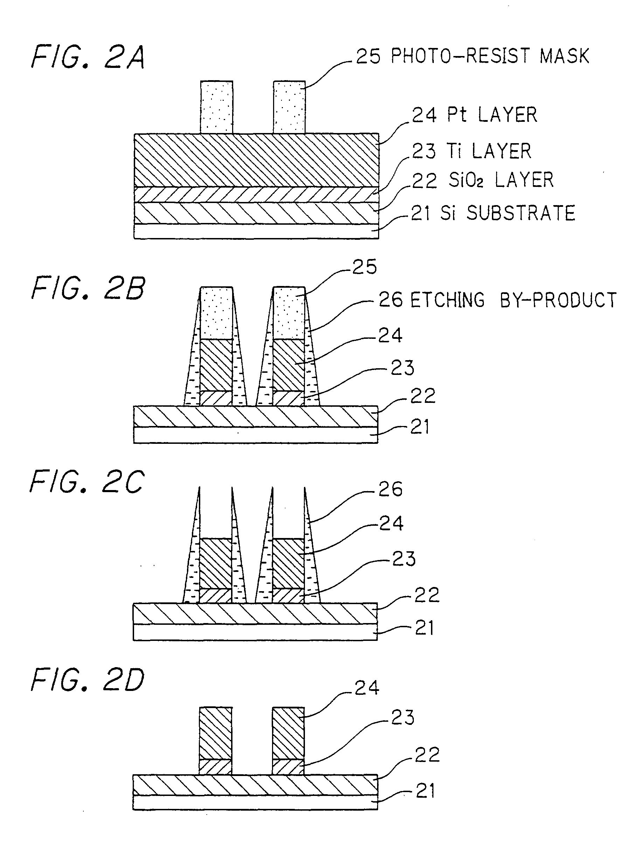

FIGs. 2A to 2D show a method for fabricating a semiconductor device according to the first preferred embodiment of the invention.

After Pt is dry etched by a $Cl_2$ gas, the main ingredients of the etching-by products (the deposited films) deposited on side walls of a Pt electrode and a photo-resist are $PtCl_2$ and metallic platinum (Pt) . After the etching process is conducted, although the photo-resist mask is ashed and stripped by oxygen plasma, the etching products are hard to removed and remain on the substrate as residues like fences, because the saturated vapor pressure of the etching by -products is low. In case that Ir or $IrO_2$ is etched, the etching by-products formed of $IrCl_4$ are deposited on the side walls of the electrode and the photo-resist, and cannot be removed after the photo-resist is ashed similarly to the aforementioned case. Then, the pending problem is solved in the invention by adopting a method that the etching by-products formed of Ir $Cl_4$ are removed by a wet process.

An outline of the invention is that the etching by-products which remain on the substrate after the photo-resist is ashed and is mainly formed of $PtCl_2$ are easily dissolved and removed by soaking the etching by-products in a mixing solution composed of either of hexafluoroacetylacetone (hfac, hereinafter) or acetoacetylacetone (acac, hereinafter) and ammonia(NH3) water. Ammonia functions as an activator, and enhances dissolving of the etching by-products.

FIG.3 shows a dry-etching apparatus used in the method for fabricating the semiconductor device according to the invention.

A vacuum vessel 10 in which plasma is generated is composed of a metallic vessel 11 having a cylindrical shape, and a quartz plate 12 provided with spiral RF antennas at a top surface thereof. A bias electrode 14 is situated on a bottom of the vacuum vessel 10 opposite to the quartz plate 12, and a semiconductor substrate 15 is set on the bias electrode 14.

A diameter of the metallic vessel 11 is 357 mm for instance, and a height thereof is 125 mm for instance, a diameter of the quartz late 12 is 357 mm for instance, and a thickness thereof is 20 mm for instance. A gas pressure in the vacuum vessel 10 is kept to be less than 10 m Torr at the time of etching. Plasma used for etching is generated by an inductively coupled discharge. The inductively coupled discharge is excited by an induced electric filed generated by the RF antennas 13 to which high frequency electric power of 13.56 MHz is supplied. Similarly, high frequency electric power of 13.56 MHz is supplied to the bias electrode 14 also. The bias electrode has a role of controlling energy of ions in plasma incident upon the semiconductor substrate.

Hereafter, a method for fabricating a semiconductor device according to the invention will be explained referring to FIGs. 2A to 2D.

First, a surface of the Si substrate 21 is oxidized by heating, and thereby a $SiO_2$ layer 22 having a thickness of 200 nm is formed on the surface of the Si substrate 21. Moreover, a Ti layer 23 having a thickness of 20 nm, and a Pt layer 24 having a thickness of 200 nm are successively formed on the $SiO_2$ layer 22 by spattering. Then, after a photo-resist to be formed into an etching mask is applied to the Pt layer 24, and a photo-resist mask 25 is formed as shown in FIG.2A by exposing and developing the photo-resist by means of a photo-lithography apparatus.

Next, the precious metal layers composed of the Pt layer 24 and the Ti layer 23 are dry etched continuously. The aforementioned etching process is conducted in accordance with following conditions. A mixture of $Cl_2$ and Ar is used as an etching gas. The amount of $Cl_2$ flow rate is 5 SCCM, and the same of Ar is 145 SCCM. The pressure of the etching gas is kept to be 5 m TORR, high frequency power of the plasma source is 1300 W, and high frequency power supplied to the bias electrode 14 is 350 W. The temperature of the Si substrate 21 is kept to be 20 °C. According to the aforementioned conditions, the etch rate of the Pt layer 24 of 250 nm/min can be obtained. As shown in FIG.2B, the etching by-products 26 formed of Pt and $PtCl_2$ are deposited on the both sides of the photo-resist mask 25 as residues like fences.

Next, in order to remove the photo-resist mask 25 which has become unnecessary, the Si substrate 21 is carried to a reaction chamber (not shown) in which the photo-resist mask 25 is ashed via vacuum transportation chamber(not shown) . In the reaction chamber, the photo-resist mask 25 is ashed and stripped by oxygen plasma. In the ashing process, the amount of $Cl_2$ flow rate is 2000 SCCM, pressure is 3 TORR, and the temperature of the Si substrate 21 is 200°C. As a result, although the photo-resist mask 25 is ashed at the ashing rate of 3 nm/min, the etching by-products 26 are not removed, and remain on the $SiO_2$ layer 22 as shown in FIG.2C.

Next, the Si substrate 21 on which the etching by-products 26 remain is soaked in a mixing solution composed of hfac, ammonia and DI water serving as a solvent. In the aforementioned process, the temperature of the mixing solution is room temperature to 80°C. As a result, the etching by-product 26 reacts with hfac, and is changed into $Pt(hfac)_2$ and dissolved. In this way, the etching by-product 26 is removed perfectly as shown in FIG. 2D.

Herein, the principle of the phenomenon that the etching by-product 26 is removed by the wet process will be explained.

When $PtCl_2$ or $Ircl_4$ is soaked in the mixing solution composed of either of hfac or acac, DI water and ammonia, chemical reactions represented by following chemical equations take place.

When $PtCl_2$ is soaked in the mixing solution composed of hfac, DI water and ammonia ($NH_3$), $PtCl_2$ is dissolved in accordance with the following chemical equation.

$$PtCl_2 + 2H(hfac) + 2NH_3 = Pt(hfac)_2 + 2NH_4Cl$$

Moreover, when $IrCl_4$ is soaked in a mixing solution composed of hfac, DI water and ammonia, $IrCl_4$ is dissolved in accordance with the following chemical equaion.

$$IrCl_4 + 3H(hfac) + 3NH_3 = Ir(hfac)_3 + 3NH_4Cl + (1/2)Cl_2$$

Although explanations are given to hfac in the above descriptions, a similar reaction takes place in case that acac is used instead of hfac.

As mentioned in the above, the etching by-product 26 which is formed of $PtCl_2$ or $IrCl_4$ and remains on the substrate as residue like a fence after the photo-resist is ashed can be easily dissolved by soaking it in the mixing solution composed of either of hfac or acac and $NH_3$. The invention can be applied to a case that the Pt layer is dry etched by the other halogenos gas such as $Br_2$ and $F_2$. The etching by-products formed of Ir or $IrO_2$ can be also removed by the same method.

Although the dry etching process using $cl_2$ gas has been exemplified in the above explanations, the invention can be also applied to the dry etching process using $Br_2$, HCl, HBr, $SF_6$ or $F_2$.

[The second preferred embodiment]

Next, the second preferred embodiment of the invention will be explained. In the second preferred embodiment, since a process that the photo-resist which has become unnecessary, after the Pt layer is etched, is ashed is the same as that in the first preferred embodiment, duplicated explanations will be omitted.

In this embodiment, in order to remove the etching by-products 26 formed of Pt and $PtCl_2$, the etching by-products 26 are soaked in a mixing solution composed of acac, ammonia and DI water serving as a solvent. In the aforementioned process, the temperature of the mixing solution is room temperature to 80°C. As a result, the etching by-products 26 react with acac and, is changed into $Pt(acac)_2$ having high saturated vapor pressure and dissolved, so that the etching by-products 26 which remain on the substrate as residues like fences are removed perfectly.

[Third Preferred Embodiment]

Next, the third preferred embodiment will be explained. In this embodiment, HBr gas is used as a dry etching gas in stead of $Cl_2$ gas. The amount of HBr flow rate is 45 SCCM, and the same of Ar gas is 155 SCCM. The pressure of the etching gas is fixed to 5 m TORR, high frequency power of the plasma source is 1100W, and the same supplied to a bias electrode is 350W. The temperature of the Si substrate 21 is kept to be 20°C. Under the aforementioned conditions, etch rate of the Pt layer 24 is 320 nm/min.

Next, in order to remove the photo-resist mask which has become unnecessary, the photo-resist mask is ashed by the same process and under the same conditions as those of the aforementioned embodiments, and the etching by-products 26 remain on the substrate 21 as residues like fences. Next, the Si substrate 21 on which the etching by-products 26 are deposited is soaked in the mixing solution composed of hfac, $NH_3$ and DI water serving as a solvent. In this case, the temperature of the mixing solution is room temperature to 80°C. As a result, the etching by-products 26 react with hfac, and is changed into $Pt(hfac)_2$ and dissolved, so that the etching by-products 26 are removed perfectly.

[The Fourth Preferred Embodiment]

Next, the fourth preferred embodiment of the invention will be explained. Since the process that the photo-resist which has become unnecessary, after the Pt layer is dry etched, is ashed in the fourth preferred embodiment is the same as those in the aforementioned embodiments, duplicated explanations will be omitted. In order to remove the etching by-products 26 which are formed of Pt and $PtBr_2$ and remain on the substrate 21 as residues like fences, the Si substrate 21 on which the etching by-products 26 remain is soaked in the mixing solution composed of acac, ammonia and DI water serving as a solvent. In this case, the temperature of the mixing solution is room temperature to 80°C. As a result, the etching by-products 26 react with acac, ad change into $Pt(acac)_2$ having the high saturated vapor pressure, and is dissolved, so that the etching by-products 26 are removed perfectly.

Although the method for removing the etching by-products formed of Pt and a halogenide of Pt after the Pt layer 24 is dry etched by a halogenous gas has been explained in the above descriptions, the etching by-products can be removed by the aforementioned method in case that Ir or $IrO_2$ is dry etched.

As mentioned in the above, according to the method for fabricating the semiconductor device according to the invention, since the etching by-products deposited on the side walls of the electrode can be dissolved in case that a precious metal layer is dry etched, the etching by-products can be effectively removed from the side walls of the electrode without dispersion of particles. As a result, the yield rate of the semiconductor device is improved, and the productivity of the fabricated goods can be heightened.

**Claims**

1. A method for fabricating a semiconductor device, comprising the steps of:

   forming a photo-resist mask having a predetermined pattern on a surface of an electrode formed of material of one kind selected from Pt, Ir, and $IrO_2$,
   dry etching said electrode by using etching gas in accordance with a pattern of said photo-resist mask,
   removing said photo-resist mask by ashing, and
   removing etching by-products deposited on both side surfaces of said electrode patterned by said dry etching by dissolving.

2. A method for fabricating a semiconductor device according to claim 1, wherein:
   said step of dry etching said electrode comprises the step of providing said etching gas by mixing one or more gases selected from $Cl_2$, HCl, $Br_2$, $SF_6$, and $F_2$ into Ar.

3. A method for fabricating a semiconductor device according to claim 1, wherein:
   said step of removing said etching by-product by dissolving comprises the steps of:

   providing a mixing solution composed of either of acetoacetylacetone or hexafluoroacetylacetone and DI water serving as a solvent, and
   soaking said etching by-product in said mixing solution.

4. A method for fabricating a semiconductor device according to claim 3, wherein:
   said mixing solution contains ammonia.

5. A method for fabricating a semiconductor device according to claim 3, wherein:
   said temperature of said mixing solution is room temperature to 80°C.

## FIG. 1A   PRIOR ART

1 PHOTO-RESIST MASK

2 PRECIOUS METAL LAYER

3 ETCHING BY-PRODUCT

## FIG. 1B   PRIOR ART

2

3

FIG. 2A

25 PHOTO-RESIST MASK

24 Pt LAYER

23 Ti LAYER

22 SiO₂ LAYER

21 Si SUBSTRATE

FIG. 2B

25

26 ETCHING BY-PRODUCT

24

23

22

21

FIG. 2C

26

24

23

22

21

FIG. 2D

24

23

22

21

# FIG. 3

10 VACUUM VESSEL

13 RF ANTENNA

12 QUARTZ PLATE

11 METALLIC VESSEL

15 SEMICONDUCTOR SUBSTRATE

14 BIAS ELECTRODE

13.56MHz

13.56MHz

EP 1 164 633 A2